# FASCICULE DE BREVET EUROPEEN

(11) **EP 0 366 173 B1**
(45) Date de publication et mention de la délivrance du brevet: **11.08.1993**
(21) Numéro de dépôt: 89202537.0
(22) Date de dépôt: 09.10.1989
(51) Int. Cl.: C30B 25/14

(54) **Réacteur d'épitaxie à collecteur de gaz amélioré**
Epitaxiereaktor mit einem verbesserten Gassammler
Epitaxy reactor with an improved gas collector

(30) Priorité: 14.10.1988 FR 8813565
(43) Date de publication de la demande: 02.05.1990
(73) Titulaire: LABORATOIRES D'ELECTRONIQUE PHILIPS, 94450 Limeil-Brévannes (FR); Philips Electronics N.V., 5621 BA Eindhoven (NL)
(72) Inventeur: Frijlink, Peter Société Civile S.P.I.D, F-75007 Paris (FR)
(74) Mandataire: Caron, Jean

(56) Documents cités:
- FR-A- 2 596 070
- US-A- 4 607 591

## Description

L'invention concerne un réacteur d'épitaxie fait d'une enceinte contenant un plateau support de plaquettes semiconductrices, avec une circulation de gaz entre le centre et la périphérie du plateau, enceinte fermée par un couvercle essentiellement plat et qui, lors du fonctionnement, est parallèle au plateau, tandis qu'une couronne collectrice de gaz comporte une cloison qui entoure le plateau, et est munie d'orifices régulièrement répartis le long de la périphérie du plateau.

Un tel réacteur est décrit dans la demande de brevet français n°2 628 984 (document intercalaire). Dans le réacteur de ce document, la couronne est une couronne circulaire en quartz, constituant une cloison verticale qui entoure le plateau, elle est munie de fentes régulièrement espacées, et est posée sur le fond de l'enceinte du réacteur.

Une telle couronne en une matière rigide présente l'inconvénient que, plus on choisit de réaliser un espace important entre la couronne et le couvercle, plus la possibilité est grande que des gaz passent par cet espace et y laissent des dépôts salissants, et au contraire plus on choisit un espace étroit, plus il y a risque de bris si un corps étranger dur et plus large que ledit espace tombe malencontreusement sur la couronne avant le serrage du couvercle. Il n'y a pas de compromis satisfaisant. Bien entendu l'utilisation d'un joint en une sorte de caoutchouc est tout à fait exclu dans cette position à cause de la température.

L'invention se propose de fournir une couronne collectrice que assure une bonne étanchéité vis à vis du couvercle, qui ne risque pas d'exercer d'efforts excessifs sur le couvercle, qui supporte la température présente dans le réacteur au niveau des plaquettes semiconductices à traiter, et enfin résiste chimiquement aux gaz employés.

Ce résultat est obtenu du fait que la cloison est faite d'une partie haute et d'une partie basse, le bord inférieur de la partie haute étant appliqué avec coulissement possible contre le bord supérieur de la partie basse, tandis que des moyens élastiques tendent à faire monter la partie haute par rapport à la partie basse, afin d'appliquer cette partie haute contre le couvercle.

Dans un mode de réalisation très avantageux, les moyens élastiques sont constitués par le fait que la couronne est un conduit faisant le tour du plateau, fait en une tôle élastique avec, du côté du plateau, deux bords de tôle qui se rejoingnent sans ètre fixés l'un à l'autre et constituent le susdit bord inférieur de la partie haute et le susdit bord supérieur de la partie basse de la cloison.

Ainsi, ce sont certaines parties de paroi du conduit qui jouent le rôle de ressort vis à vis d'autres parties constituant la susdite cloison.

Pour réaliser ce conduit, il est avantageux de partir d'une tôle unique, le conduit étant formé des parties de cette tôle repliée sur elle-même d'une part le long de lignes de pliage horizontales afin de constituer un conduit de section polygonale fermé, et d'autre part le long de lignes de pliage verticales régulièrement espacées, le conduit ayant ainsi la forme générale d'un polygone entourant le plateau.

La tôle est de préférence une tôle de molybdène.

Afin de réduire la zone de contact des gaz avec le couvercle, le conduit possède avantageusement un toit incliné dont le faite est situé du côté du plateau.

Dans un mode de réalisation particulier, la couronne comporte une partie horizontale liée à la partie basse de la cloison et elle est posée, au moyen de cette partie horizontale, sur la bord du plateau.

Ainsi, le ligne le long de laquelle la couronne est posée sur le plateau constitue une ligne de joint à peu près étanche, que évite que des gaz ne pénètrent entre le bord du plateau et la couronne.

La description qui va suivre, en regard des dessins annexés décrivant des exemples non limitatifs fera bien comprendre comment l'invention peut être réalisée.

La figure 1 est une coupe diamétrale dans un réacteur globalement cylindrique.

La figure 2 est une vue de dessus de réacteur de la figure 1, couvercle enlevé.

La figure 3 est une vue en perspective et à plus grande échelle d'un morceau de la couronne collectrice de gaz.

La figure 4 représente une tôle à partir de laquelle le conduit est réalisé par pliage.

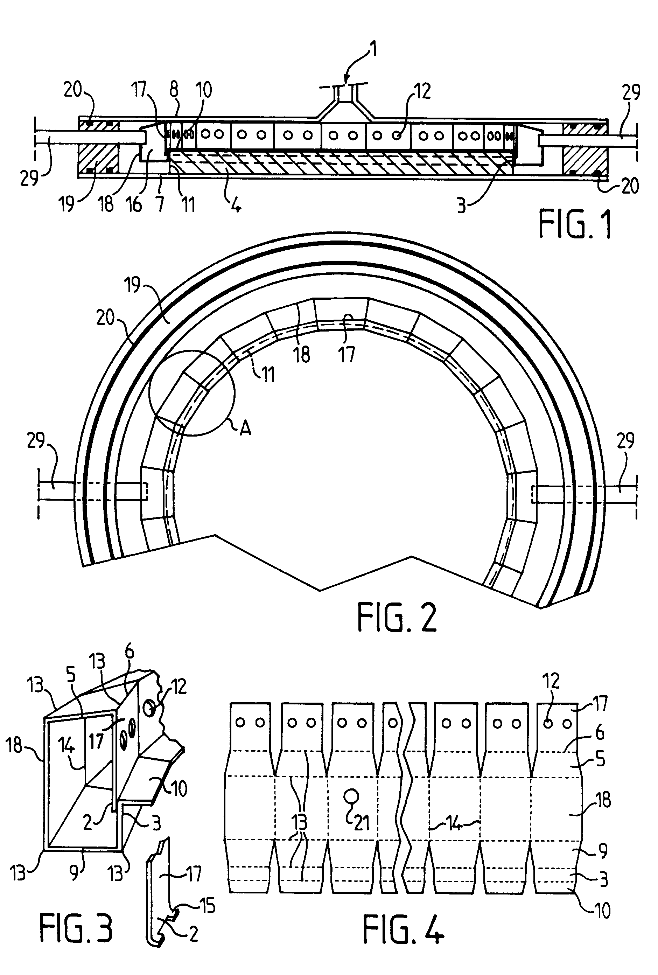

Le réacteur représenté sur les figures 1 et 2 est globalement cylindrique d'axe vertical. Seuls les éléments essentiels pour la présente invention sont représentés.

Le réacteur est muni d'un plateau 4 circulaire fixe d'un diamètre d'environ 25 cm, qui supporte à son tour un système de disques tournants non représentés, sur lesquels sont posées les plaquettes semiconductrices, et pour la description desquels on peut consulter le document déjà mentionné ou bien le document FR-A-2 596 070.

Ce plateau 4 est placé à l'intérieur d'une enceinte dans laquelle des gaz réactifs sont en contact avec les plaquettes. L'enceinte est constituée d'un corps cylindrique 19 d'axe vertical qui entoure le plateau support 4. Sur les sections inférieure et supérieure de ce corps cylindrique sont appliqués respectivement un fond 7 constitué d'une plaque, et un couvercle 8 globalement plat. L'étanchéité est assurée par des joints toriques 20. Le couvercle 8 peut être soulevé pour mettre en place des plaquettes semiconductrices à traiter sur le plateau 4. Il est pratiquement parallèle au plateau, dans la position représentée, pendant le fonctionnement, au cours duquel des gaz réactifs sont introduits dans l'enceinte par un orifice 1 (pour le détail duquel on peut à nouveau se reporter au document mentionné en préambule) et se déplacent radialement au-dessus du plateau 4 vers la périphérie de celui-ci, où ils sont recueillis par une couronne collectrice de gaz 17, 18, munie de trous 12 régulièrement espacés.

Une partie A (figure 2) de cette couronne est représentée en détail sur la figure 3. Elle est faite d'une tôle de molybdène élastique repliée de façon à constituer une enveloppe fermée. A partir d'un des bords 2 de la tôle, on trouve des parties de tôle plane référencées successivement 17, 5, 18, 9, 3, 10, reliées l'une à l'autre à chaque fois le long d'une ligne de pliage horizontale 13. Les bords de tôle 2 et 3 se rejoignent du côté du plateau sans être fixés l'un à l'autre. Tout ceci constitue donc un conduit.

L'élément essentiel de cette couronne est la cloison verticale constituée par les parties 17 et 3, le bord inférieur 2 de la partie haute 17 étant appliqué avec coulissement possible contre le bord supérieur 3 de la partie basse. La partie 10 horizontale liée à la partie basse 3 sert à poser la couronne sur le bord du plateau 4. En outre la partie supérieure 5, c'est-à-dire le toit du conduit, est inclinée et son faîte 6 est situé du côté du plateau.

Grâce à des lignes de pliage verticales 14, le conduit est divisé en portions successives qui font un angle en elles, le tout constituant ainsi un polygone qui entoure le plateau (sur la figure 2 le polygone partiellement représenté est un polygone à 24 côtés).

Lorsque la couronne est posée sur le plateau dans le réacteur dont le couvercle 8 n'est pas encore en place, la partie la plus haute 6 de la couronne est un peu plus haute que la surface supérieure du corps cylindrique 19 du réacteur. Ainsi lorsqu'on met en place le couvercle 8, ce dernier appuie sur le faîte 6 du toit 5. La partie 10 étant posée sur le plateau fixe, les parties de tôle 3, 9, 18, 5 constituent un ressort qui tend à faire monter la partie haute 17 par rapport à la partie basse 3, afin d'appliquer cette partie haute contre le couvercle.

On peut remarquer d'ailleurs que la force vers le bas appliquée au conduit est reportée sur la partie horizontale 10, assurant aussi un ferme contact de cette partie 10 sur le plateau 4.

La coupe de la figure 1 montre clairement que le gaz introduit par l'orifice 1 ne peut pas passer entre le faîte de la couronne et le couvercle 8 ni entre le rebord horizontal 10 et le plateau 4. Il passe donc exclusivement par les orifices 12 et ne provoque pas de dépôt salissant, ni sur le couvercle, ni sur la périphérie du plateau.

Si une particule dure, par exemple un morceau de semiconducteur cassé, tombe sur le haut de la couronne, du fait de l'élasticité des parois 9, 18, 6, cela ne risque pas d'entraîner le bris du couvercle (qui est réalisé en quartz et est donc à la fois fragile et coûteux).

Deux tubes 29 diamétralement opposés débouchent à l'intérieur du conduit 16 pour évacuer les gaz vers l'extérieur.

Au lieu du trou 12, on pourrait imaginer, comme le montre l'élément dessiné en bas à droite de la figure 3, que la partie de paroi 17 soit munie de saillies inférieures repliées 15 écartant le bord mobile 2 du bord fixe 3 et laissant ainsi une fente entre les bords 2 et 3, par laquelle le gaz peut alors passer.

La figure 4 montre comment on peut réaliser tout le conduit à partir d'une tôle d'une seule pièce découpée. Il y a par exemple 24 portions identiques dont seules les portions d'extrémité sont représentées ici. Les lignes de pliage indiquées en pointillé ont les mêmes références 13, 14 que sur la figure 3, ainsi que les parties de conduit 10, 3, 9, 18, 5, 6, 17, ce qui permet de comprendre immédiatement comment le conduit est réalisé. Les lignes de pliage sont marquées par exemple d'un pointillé de trous faits au moyen d'un laser. De ce fait, en opérant à la main, la tôle se plie d'elle-même le long des lignes prévues. Le trou 21 est destiné au passage d'un tube (29) d'évacuation de gaz. Pour refermer le conduit autour du plateau, ses deux extrémités peuvent être fixées l'une à l'autre au moyen de pinces ou de tout autre moyen mécanique connu.

Des variantes de réalisation différentes de celles décrites ci-dessus, peuvent être imaginées, correspondant toujours au moins à la première revendication. Par exemple, le conduit peut être fait de bandes métalliques circulaires soudées entre elles ; le fond 9 du conduit peut aussi être posé sur la fond 7 du réacteur, avec toute fois les inconvénients signalés plus haut.

## Revendications

1. Réacteur d'épitaxie fait d'une enceinte contenant un plateau support de plaquettes semiconductrices, avec une circulation de gaz entre le contre et la périphérie du plateau, enceinte fermée par un couvercle essentiellement plat et qui, lors du fonctionnement, est parallèle au plateau, tandis qu'une couronne collectrice de gaz comporte une cloison qui entoure le plateau et est munie d'orifices régulièrement répartis le long de la périphérie du plateau, la cloison e'tant faite d'une partie haute et d'une partie basse, le bord inférieur de la partie haute étant appliqué avec coulissement possible contre le bord supérieur de la partie basse, tandis que des moyens élastiques tendent à faire monter la partie haute par rapport à la partie basse, afin d'appliquer cette partie haute contre le couvercle.

2. Réacteur selon le revendication 1, caractérisé en ce que la couronne est un conduit faisant le tour du plateau, fait en une tôle élastique avec, du côté du plateau, deux bords de tôle qui se rejoingnent sans être fixés l'un à l'autre et constituent le susdit bord inférieur de la partie haute et le susdit bord supérieur de la partie basse de la cloison.

3. Réacteur selon la revendication 2, caractérisé en ce que le conduit est formé à partir d'une tôle unique repliée sur elle-même d'une part le long de lignes de pliage horizontales afin de constituer un conduit de section polygonale fermé, et d'autre part le long de lignes de pliage verticales régulièrement espacées, le conduit ayant ainsi la forme générale d'un polygone entourant le plateau.

4. Réacteur selon l'une quelconque des revendications 2 ou 3, caractérisé en ce que le conduit possède un toit incliné dont le faîte est situé du côté du plateau.

5. Réacteur selon l'une quelconque des revendications 2 à 4 caractérisé en ce que la tôle est une tôle de molybdène.

6. Réacteur selon l'une quelconque des revendications précédentes, caractérisé en ce que la couronne comporte une partie horizontale liée à la partie basse de la cloison et elle est posée, au moyen de cette partie horizontale, sur le bord du plateau.

## Claims

1. An epitaxy reactor comprising a space containing a platform supporting semiconductor wafers with a circulation of gas between the centre and the periphery of the platform, which space is closed by a cover which is substantially flat and is parallel to the platform during operation, while a gas-collecting crown comprises a baffle plate which surrounds the platform and is provided with inlets regularly distributed along the periphery of the platform, wherein the baffle plate comprises an upper part and a lower part, the lower edge of the upper part being pressed with sliding possibility against the upper edge of the lower part, while elastic means urge the upper part upward with respect to the lower part in order to press this upper part against the cover.

2. A reactor as claimed in Claim 1, characterized in that the crown is a conduit surrounding the platform and comprising an elastic plate having two plate edges on the side of the platform, which are joined without being fixed together and constitute the aforementioned lower edge of the upper part and the aforementioned upper edge of the lower part of the baffle plate.

3. A reactor as claimed in Claim 2, characterized in that the conduit is formed from a single plate folded onto itself on the one hand along horizontal folding lines in order to constitute a closed conduit having a polygonal cross-section and on the other hand along vertical folding lines regularly spaced apart, the conduit thus having the general shape of a polygon surrounding the platform.

4. A reactor as claimed in any one of Claims 2 or 3, characterized in that the conduit has an inclined roof whose ridge is situated on the side of the platform.

5. A reactor as claimed in any one of Claims 2 to 4, characterized in that the plate is a plate of molybdenum.

6. A reactor as claimed in any one of the preceding Claims, characterized in that the crown comprises a horizontal part connected to the lower part of the baffle plate and is placed on the edge of the platform by means of said horizontal part.

## Patentansprüche

1. Epitaxiereaktor mit einem Raum, der eine Plattform zum Unterstützen von Halbleiterscheiben enthält, mit einem Gasumlauf zwischen der Mitte und dem Umkreis der Plattform, welcher Raum mit einem Deckel abgeschlossen wird, der im wesentlichen flach ist und im Betrieb parallel zur Plattform verläuft, während eine Gaskollektorkrone eine die Plattform umgebende Zwischenwand enthält, die mit in regelmäßigen Abständen auf dem Umkreis der Plattform verteilten Einführungsöffnungen versehen ist, wobei die Zwischenwand aus einem oberen und einem unteren Teil besteht und der untere Rand des oberen Teils verschiebbar gegen den oberen Rand des unteren Teils anliegt, während elastische Mittel dazu tendieren, den oberen Teil in bezug auf den unteren Teil anzuheben, um diesen oberen Teil gegen den Deckel zu drücken.

2. Reaktor nach Anspruch 1, dadurch gekennzeichnet, daß die Krone ein die Plattform umgebendes Rohr ist und aus einer elastischen Platte besteht, die an der Seite der Plattform zwei Plattenränder enthält, die zusammengefügt werden, ohne aneinander befestigt zu werden, und den erwähnten unteren Rand des oberen Teils und den erwähnten oberen Rand des unteren Teils der Zwischenwand bilden.

3. Reaktor nach Anspruch 2, dadurch gekennzeichnet, daß das Rohr aus der zusammengefalteten Platte einerseits entlang der horizontalen Faltlinien zur Bildung eines geschlossenen Rohrs mit einem Polygonalquerschnitt und andererseits entlang vertikaler Faltlinien, die in regelmäßigen Abständen auseinander liegen, gebildet wird, wobei das Rohr also die allgemeine Form eines Polygons hat, das die Plattform umgibt.

4. Reaktor nach einem der Ansprüche 2 oder 3, dadurch gekennzeichnet, daß das Rohr ein geneigtes Dach enthält, dessen First sich an der Seite der Plattform befindet.

5. Reaktor nach einem der Ansprüche 2 oder 4, dadurch gekennzeichnet, daß die Platte eine Molybdänplatte ist.

6. Reaktor nach einem oder mehreren der vorangehenden Ansprüche, dadurch gekennzeichnet, daß die Krone einen mit dem unteren Teil der Zwischenwand verbundenen horizontalen Teil enthält und mit Hilfe dieses horizontalen Teils auf dem Rand der Plattform angeordnet ist.
